# DEMANDE DE BREVET EUROPEEN

(11) **EP 4 390 929 A1**
(43) Date de publication de la demande: **26.06.2024**
(21) Numéro de dépôt: 23218361.6
(22) Date de dépôt: 19.12.2023
(51) Int. Cl.: G11C 7/24, G11C 7/20, G11C 11/419, G11C 7/12, G11C 29/44

(54) **MÉMOIRE SRAM À INITIALISATION DÉTERMINISTE ALÉATOIRE**

(30) Priorité: 20.12.2022 FR 2213917
(71) Demandeur: Commissariat à l'énergie atomique et aux énergies alternatives, 75015 Paris (FR)
(72) Inventeur: NOEL, Jean-Philippe, 38054 GRENOBLE CEDEX 09 (FR); GIRAUD, Bastien, 38054 GRENOBLE CEDEX 09 (FR)
(74) Mandataire: Brevalex

(57) **Abrégé**

Dispositif de mémoire statique à accès aléatoire comprenant une matrice dans laquelle chaque colonne est associée à un circuit d'initialisation (100i, 100j), pourvu d'un étage (110) de tirage de valeur aléatoire (110) configuré pour, consécutivement à la réception du signal d'activation d'initialisation (RAND_ENABLE), produire, de manière aléatoire, respectivement un premier potentiel à un premier noeud (NA) correspondant à un état logique donné et un deuxième potentiel à un deuxième noeud (NB) de sortie différent du premier potentiel et correspondant à un état logique donné complémentaire dudit état logique donné, afin d'initialiser des cellules d'une même colonne à un état donné et sélectionné de manière aléatoire entre deux états.

## Description

### DOMAINE TECHNIQUE

La présente invention se rapporte au domaine des mémoires, et en particulier de type SRAM (SRAM pour « *Static Random Access Memory* » ou mémoire vive statique à accès aléatoire), et concerne plus précisément celui de l'initialisation des mémoires SRAM.

La présente invention met en oeuvre un circuit d'initialisation amélioré.

### ÉTAT DE LA TECHNIQUE ANTÉRIEURE

Les transistors en technologie PMOS subissent un phénomène physique appelé NBTI (en anglais « *Negative-Bias Température Instability »,* c'est à dire *« Instabilité de température en polarisation négative »),* qui a pour effet d'augmenter leur tension de seuil, ceci d'autant plus lorsque leurs dimensions sont réduites. Ce phénomène est par ailleurs accéléré quand la température et/ou la tension négative VGS appliquée entre la grille et la source du transistor augmentent.

Une cellule mémoire SRAM est communément dotée de deux inverseurs connectés de façon croisée tête-bêche, chacun étant formé notamment d'un premier transistor de type P et d'un deuxième transistor de type N, avec un ratio VTP1/VTP2 de leurs tensions de seuil respectives des deux transistors PMOS.

La valeur mémorisée dans une cellule mémoire SRAM va influencer différemment les transistors PMOS d'une cellule mémoire et le ratio VTP1/VTP2 va évoluer dans le temps dans un sens ou dans l'autre en fonction de la valeur mémorisée.

Ainsi, le phénomène NBTI influence la probabilité d'une cellule SRAM à s'initialiser spontanément (lors de sa mise sous tension) au niveau logique '1' ou à son niveau opposé '0', étant donné que le niveau logique d'initialisation est lié au ratio VTP1/VTP2.

Or, des données mémoires issues de l'initialisation de cellules SRAM peuvent être utilisées pour générer des clés de chiffrement ou un identifiant matériel ou une empreinte numérique unique. Elles peuvent être utilisées pour constituer ainsi une fonction physique non clonable (PUF pour « *Physical Unclonable Function »).*

Certaines cellules présentant un fort ratio VTP1/VTP2 peuvent être en particulier identifiées comme cellules suffisamment stables pour être utilisées pour constituer un PUF lors d'une phase dite d'enrôlement (« *enrollment »* en anglais).

Néanmoins, à cause des effets du phénomène NBTI précité, le ratio VTP1/VTP2 peut avec le temps être amené à être modifié, ce qui rend les cellules moins propices à leur utilisation pour constituer un PUF.

Pour limiter une telle dégradation avec le temps des cellules SRAM, une technique consiste à inverser le contenu de rangées horizontales de cellules mémoire de manière régulière. Une telle technique induit une augmentation de la consommation et s'avère pénalisant en termes de temps pendant lequel le système peut avoir accès aux cellules mémoires.

Des techniques d'inversion de bit sont présentées dans le document *"*Impact of NBTI on SRAM Read Stability and Design for Reliability", de S. Kumar et al., ISQED 2006 ou dans le document *"*A Secure Data-Toggling SRAM for Confidential Data Protection", de W.-G. Ho et al., IEEE TCAS-I 2019. Dans ce dernier document, la solution proposée a pour inconvénient de modifier la structure de cellule en ajoutant des transistors supplémentaires. Dans tous les cas, l'inversion périodique des bits entraîne une perte de temps et d'énergie au circuit utilisateur de mémoire.

Une problématique liée aux effets du NBTI et qui influe sur la sécurisation des données est l'effet dit « d'impression des données » (« *data imprint effect* »). Un tel effet est décrit dans le document : *"*Challenging On-Chip SRAM Security with Boot-State Statistics", de J. McMahan et al., HOST 2017. Lorsqu'une donnée stockée en mémoire y reste longtemps (avec une mémoire en fonctionnement, sous alimentation électrique) , la tension de seuil VTP du transistor PMOS passant évolue, dû au même effet physique qui cause le NBTI. Un effet de rémanence néfaste ou « d'impression des données » (« data imprint » en anglais) fait alors qu'il peut être possible de retrouver une donnée qui a été stockée préalablement même lorsque la mémoire est réinitialisée.

Des techniques telles que l'« analyse de consommation » (connues sous le nom de « CPA » ou « DPA » selon les acronymes anglais « correlated Power analysis » ou « differential power analysis ») peuvent être employées pour révéler des données destinées à rester secrètes, en se basant entre autre sur ce phénomène de dérive de la tension de seuil des transistors en utilisant des moyens pour accélérer cette dérive. Une telle technique est décrite par exemple dans le document : *"*Power Analysis Résilient SRAM Design Implemented with a 1% Area Overhead Impédance Randomization Unit for Security Applications", de R. Giterman et al., ESSCIRC 2019.

Il se pose le problème de réaliser un dispositif mémoire amélioré vis-à-vis d'au moins une des problématiques évoquées ci-dessus.

### EXPOSÉ DE L'INVENTION

Selon un aspect, la présente invention concerne un dispositif de mémoire comprenant une matrice mémoire agencée en lignes et en colonnes de cellules mémoires SRAM, chaque colonne comprenant une première ligne de bit et une deuxième ligne de bit complémentaire reliées respectivement à des transistors d'accès des cellules mémoire de la colonne, chaque colonne étant associée à un circuit d'initialisation comprenant un premier élément de couplage et un deuxième élément de couplage placés respectivement entre d'une part les première et deuxième lignes de bits de la colonne associée et d'autre part un bloc de pilotage, le bloc de pilotage étant apte à imposer une tension sur les lignes de bit quand au moins un desdits éléments de couplage est rendu conducteur dans un mode d'initialisation déterministe de tout ou partie des cellules de la colonne, et dans lequel ledit bloc de pilotage comprend au moins un étage de tirage de valeur aléatoire, pour générer une valeur parmi deux valeurs possibles « 0 » ou « 1 » associé à une colonne, et dans lequel, dans une phase d'initialisation dite « déterministe aléatoire », le bloc de pilotage commande successivement pour au moins une colonne sélectionnée :
- la génération d'une valeur aléatoire par ledit étage de tirage de valeur aléatoire associé à chaque colonne sélectionnée ; puis
- la mise en conduction d'au moins un élément de couplage parmi lesdits premier et deuxième éléments de couplage d'un circuit d'initialisation associé à chaque colonne sélectionnée pour relier au moins une des lignes de bits au bloc de pilotage qui impose une valeur de tension, le choix dudit élément couplage mis en conduction ou le choix de la valeur de tension imposée étant fonction de la valeur aléatoire préalablement générée pour la colonne sélectionnée, et la mise en conduction simultanée d'au moins un transistor d'accès d'au moins une cellule de la colonne sélectionnée.

L'étage de tirage de valeur aléatoire est apte à être couplé à une colonne de cellules parmi lesdites colonnes et doté d'un premier noeud de sortie et d'un deuxième noeud de sortie, ledit étage de tirage de valeur aléatoire étant configuré pour, consécutivement à la réception d'un signal d'activation d'initialisation, produire, de manière aléatoire, respectivement un premier potentiel au premier noeud correspondant à un état logique donné et un deuxième potentiel au deuxième noeud de sortie différent du premier potentiel et correspondant à un état logique donné complémentaire dudit état logique donné,
au moins un premier circuit d'initialisation associé à une première colonne étant configuré pour, préalablement à une phase dite d'« initialisation déterministe aléatoire » :
   - isoler le premier noeud de sortie et le deuxième noeud de sortie respectivement d'une première ligne de bit et d'une deuxième ligne de bit de ladite première colonne tout en mettant le premier noeud de sortie et le second noeud à un même potentiel,
puis, lors de la phase d'initialisation déterministe aléatoire déclenchée par la réception dudit signal d'activation d'initialisation,
   - laisser le premier noeud de sortie et le second noeud s'établir respectivement à des potentiels différents, tout en couplant le premier noeud de sortie à ladite première ligne de bit et le deuxième noeud de sortie à ladite deuxième ligne de bit de la première colonne.

Avantageusement, l'étage de tirage de valeur aléatoire est doté d'un premier inverseur et d'un deuxième inverseur mutuellement connectés de façon croisée.

Selon une possibilité de mise en oeuvre, le circuit d'initialisation comprend :
- un étage de commutation à transistors, agencé entre un premier élément de polarisation et les noeuds de sortie dudit étage de tirage de valeur aléatoire, configuré pour, hors de phases d' initialisation déterministe aléatoire », connecter les noeuds de sortie dudit étage de tirage de valeur aléatoire au premier élément de polarisation et pour isoler les noeuds de sortie de l'étage de tirage de valeur aléatoire dudit premier élément de polarisation lors desdites phases d'initialisation déterministe aléatoire,
- un élément interrupteur, en particulier un transistor, configuré pour, hors desdites phases d'initialisation déterministe aléatoire, isoler ledit étage de tirage de valeur aléatoire d'un deuxième élément de polarisation et lors desdites phases d'initialisation déterministe aléatoire, connecter ledit étage de tirage de valeur aléatoire audit deuxième élément de polarisation.

Selon une possibilité de réalisation, l'étage de commutation à transistors peut être configuré en outre pour hors desdites phases d'initialisation déterministe aléatoire, isoler l'un de l'autre les noeuds de sortie dudit étage de tirage de valeur aléatoire et lors desdites phases d'initialisation déterministe aléatoire, connecter l'un à l'autre les noeuds de sortie dudit étage de tirage de valeur aléatoire.

Selon une possibilité de mise en oeuvre, le premier élément de couplage est un premier transistor de couplage entre la première ligne de bit et un premier noeud de sortie de l'étage de tirage de valeur aléatoire, dans lequel le deuxième élément de couplage est un deuxième transistor de couplage agencé entre la deuxième ligne de bit et un deuxième noeud de sortie de l'étage de tirage de valeur aléatoire, le premier transistor de couplage et le deuxième transistor de couplage étant commandés par ledit signal d'activation d'initialisation déterministe aléatoire.

Avantageusement, l'étage de tirage de valeur aléatoire peut comprendre un circuit partagé de tirage d'un nombre aléatoire sur plusieurs bits, chaque bit étant associé à une colonne.

Selon une mise en oeuvre possible du dispositif, au moins une partie de la matrice de cellules mémoire inclut des cellules dites sensibles et le dispositif comprend un contrôleur mémoire apte à imposer une initialisation déterministe aléatoire de ces cellules sensibles lors d'une mise sous tension du dispositif mémoire ou consécutivement à une opération d'effacement de la matrice mémoire.

Selon un autre aspect, la présente demande concerne un dispositif de mémoire statique à accès aléatoire comprenant une matrice mémoire agencée en lignes et en colonnes de cellules mémoires SRAM, chaque colonne étant associée à un circuit d'initialisation, un premier circuit d'initialisation parmi lesdites circuit d'initialisation associé à une première colonne parmi lesdites colonnes étant pourvu d'un étage apte à être couplé à une colonne de cellules parmi lesdites colonnes et doté d'un premier noeud de sortie et d'un deuxième noeud de sortie, ledit étage de tirage aléatoire étant configuré pour, consécutivement à la réception du signal d'activation d'initialisation, produire, de manière aléatoire, respectivement un premier potentiel au premier noeud correspondant à un état logique donné et un deuxième potentiel au deuxième noeud de sortie différent du premier potentiel et correspondant à un état logique complémentaire dudit état logique donné, le premier circuit d'initialisation étant configuré pour, préalablement à une phase dite d'initialisation déterministe aléatoire :
- isoler le premier noeud de sortie et le deuxième noeud de sortie respectivement d'une première ligne de bit et d'une deuxième ligne de bit de ladite colonne tout en mettant le premier noeud de sortie et le second noeud à un même potentiel, puis, lors de la phase d'initialisation déterministe aléatoire déclenchée par la réception dudit signal d'activation d'initialisation :
- laisser le premier noeud de sortie et le second noeud s'établir respectivement à des potentiels différents, tout en couplant le premier noeud de sortie à ladite première ligne de bit et le deuxième noeud de sortie à ladite deuxième ligne de bit.

Avec un tel circuit d'initialisation, une nouvelle manière d'initialiser à un même état déterminé les cellules d'une même colonne est ainsi prévue et permet de notamment de pallier le phénomène d'impression des données. Un tel circuit participe à une meilleure sécurisation des données et rend plus fiable l'utilisation de certaines cellules mémoires notamment celles pour constituer un PUF.

Selon une possibilité de mise en oeuvre, le circuit d'initialisation comprend :
- un étage de commutation à transistors, agencé entre un moyen de polarisation, et les noeuds de sortie dudit étage, configuré pour, hors de phases déterministe aléatoire, connecter les noeuds de sortie dudit étage de tirage aléatoire au premier élément de polarisation et pour isoler les noeuds de sortie dudit étage de tirage aléatoire dudit premier élément de polarisation lors desdites phases déterministe aléatoire,
- un élément interrupteur, en particulier un transistor, configuré pour hors desdites phases déterministe aléatoire isoler ledit étage de tirage d'un élément de polarisation et lors desdites phases déterministe aléatoire, connecter ledit étage de tirage aléatoire audit élément de polarisation.

Avantageusement, l'étage de commutation à transistors peut être est configuré en outre pour hors desdites phases déterministe aléatoire, isoler l'un de l'autre les noeuds de sortie dudit étage de tirage et lors desdites phases déterministe aléatoire, connecter l'un à l'autre les noeuds de sortie dudit étage de tirage.

Selon une possibilité de mise en oeuvre, le circuit d'initialisation comprend :
- un premier transistor de couplage entre la première ligne de bit et le premier noeud de sortie,
- un deuxième transistor de couplage agencé entre la deuxième ligne de bit et le deuxième noeud de sortie, le premier transistor de couplage et le deuxième transistor de couplage étant commandés par ledit signal d'activation d'initialisation déterministe aléatoire.

Avantageusement lors de la phase dite déterministe aléatoire :
- ledit étage de tirage dudit premier circuit d'initialisation produit respectivement un premier potentiel à son premier noeud et un deuxième potentiel à son deuxième noeud, différent du premier potentiel et correspondant à un état logique complémentaire dudit premier état logique,
- un deuxième circuit d'initialisation associé à une deuxième colonne parmi lesdites colonnes étant pourvu d'un deuxième étage de tirage identique audit étage de tirage et produisant respectivement, ledit deuxième potentiel et ledit premier potentiel respectivement à son premier noeud de sortie et à son deuxième noeud de sortie.

Avantageusement, lors d'une phase ultérieure déterministe aléatoire, ledit étage de tirage dudit premier circuit d'initialisation produit, consécutivement à la réception dudit même signal d'activation d'initialisation respectivement un premier potentiel à son premier noeud de sortie et un deuxième potentiel à son deuxième noeud de sortie.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels°:
La figure 1 illustrer une matrice de cellules mémoires SRAM dont les colonnes sont dotées chacune d'un circuit d'initialisation déterministe aléatoire de colonne tel que mis en oeuvre suivant l'invention.
La figure 2 illustre une cellule mémoire SRAM d'agencement conventionnel et susceptible d'être intégrée dans un dispositif mémoire suivant l'invention.
La figure 3 illustre un exemple de réalisation de circuit d'initialisation déterministe aléatoire de colonne pour initialiser les cellules d'une même colonne de cellules de manière aléatoire d'une initialisation à l'autre.
Les figure 4A et 4B illustrent différents états auxquels peuvent être mis les lignes de bits couplés au circuit d'initialisation de colonne.
La figure 5 illustre différentes colonnes d'une matrice de cellule dont les colonnes sont initialisées indépendamment l'une de l'autre par le biais de leurs circuits d'initialisation respectifs.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

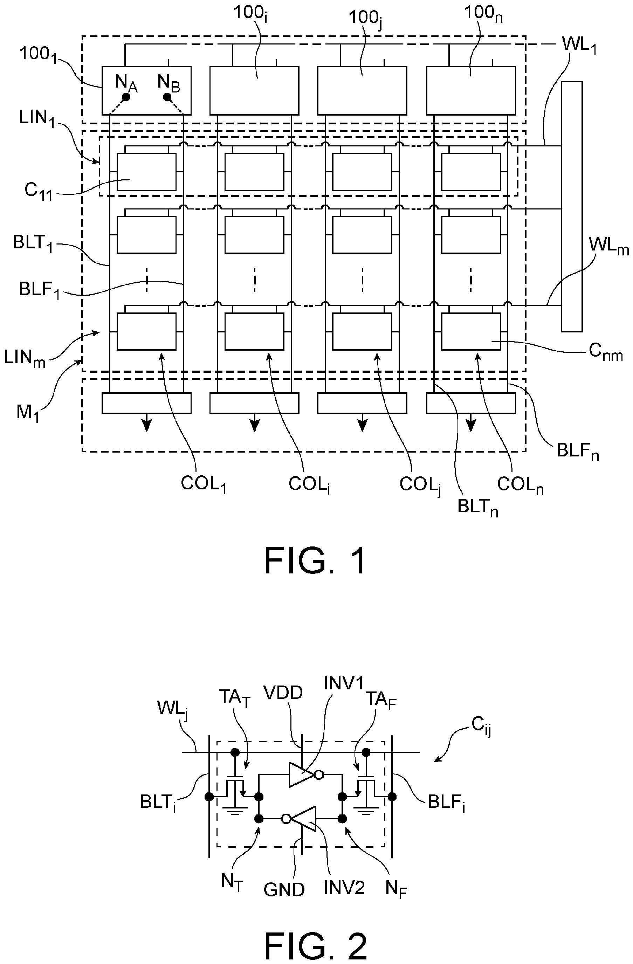

Un exemple de dispositif mémoire SRAM est donné sur la figure 1 et comporte un plan mémoire M₁ formé d'une pluralité de colonnes COL₁, ..., COLₙ (avec n un entier strictement supérieur à 1, les colonnes correspondant dans cet exemple à des rangées verticales) et de lignes LIN₁, ..., LINₘ (avec m un entier strictement supérieur à 1, les lignes correspondant sur la figure 1 à des rangées horizontales) comprenant n*m cellules mémoire SRAM distinctes C₁₁, ..., Cₙₘ.

De manière conventionnelle, chaque colonne de cellules est associée à une paire de lignes de bits parmi un ensemble de paires de lignes de bits BLT₁, BLF₁,..., BLTₙ, BLFₙ. De même, chaque ligne de cellules est typiquement associée à une ligne de mot parmi un ensemble de lignes de mots WL₁, ..., WLₘ. Chaque ligne de mot permet, lorsqu'elle est activée, de sélectionner les cellules mémoires d'une ligne donnée de cellules SRAM parmi lesdites lignes de cellules SRAM.

Une phase d'initialisation des cellules de la mémoire SRAM est prévue lors de la mise sous tension du dispositif mémoire, mais également consécutivement à une opération d'effacement de la mémoire par exemple à la suite d'une détection d'une tentative d'accès frauduleux à la mémoire sans qu'il soit prévu d'éteindre tout le dispositif mémoire pour réinitialiser le contenu de la mémoire. Lors d'une opération d'effacement de la mémoire, les noeuds internes des cellules mémoires peuvent être positionnés à des valeurs identiques ou sensiblement identiques (i.e. qui diffèrent de moins 10 mV), soit par court-circuit, soit par décharge des noeuds suite à une coupure d'alimentation. Une phase possible d'initialisation consiste donc à faire passer une cellule mémoire d'un état « indéterminé » (et indéterminable par lecture) à un état avec une valeur mémorisée « déterminée » (et donc déterminable par lecture).

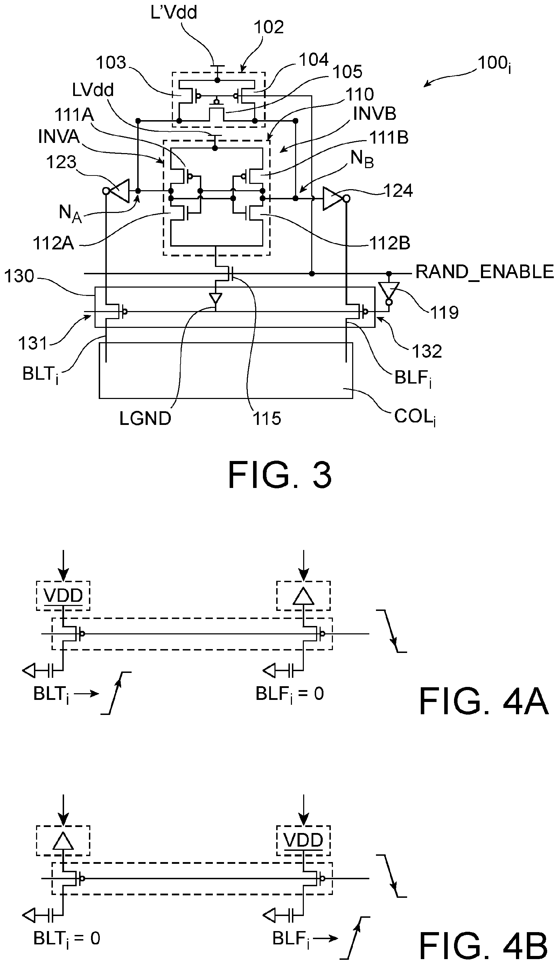

La présente demande fait suite à d'autres demandes de brevets de la demanderesse en lien avec le sujet des dispositifs mémoires SRAM. Ainsi, on peut se référer à la demande de brevet FR, n°1761692, déposée le 6 décembre 2017 dans laquelle un mécanisme d'effacement rapide est décrit. On peut également se référer à une deuxième demande de brevet français n°2111286 déposée par la demanderesse le 25 Octobre 2021 devant l'Institut National de la Propriété Intellectuelle dans laquelle il est décrit un dispositif d'initialisation de la mémoire SRAM, selon plusieurs modes possibles, un mode libre et un mode déterministe. Nous reprenons par la suite un vocabulaire commun avec cette deuxième demande de brevet. Un mode d'initialisation dit « libre », consiste à laisser chaque cellule mémoire s'initialiser à une valeur propre lors de la mise sous tension progressive des éléments constituants la cellule mémoire, notamment de deux inverseurs rebouclés tels qu'illustrés sur la figure 2, sans chercher à imposer de valeur « 0 » ou « 1 » sur les noeuds internes N_{T} et N_{F} de la cellule. Dans le mode d'initialisation libre, les transistors d'accès TA_{T} et TA_{F} sont non passants, la cellule étant comme « isolée » des autres cellules et des lignes de bits BLT et BLF. Par opposition, un mode d'initialisation dit « déterministe » consiste à imposer ou forcer une valeur à mémoriser par la cellule lors de son passage d'un état indéterminé à un état déterminé. Pour imposer une valeur pendant l'initialisation, le dispositif mémoire comprend en pied de colonne des moyens pour imposer une valeur sur les noeuds internes des cellules en cours d'initialisation, via les lignes de bits et en rendant conducteurs les transistors d'accès de des cellules concernées. Dans cette deuxième demande de brevet, la valeur d'initialisation que l'on souhaite imposer peut être « 0 » ou « 1 ». Les moyens d'initialisation déterministe décrits dans cette deuxième demande, notamment en lien avec sa figure 4, permettent d'écrire toutes les cellules mémoire soit à « 0 » soit à « 1 ». Pour ce faire, le dispositif prévoit de piloter, pour chaque colonne, une des lignes de bits BLT ou BLF en la connectant à une tension d'alimentation par mise en conduction d'un transistor de sélection de ligne de bits. La ligne de bits sélectionnée et alimentée tend ainsi à imposer une valeur « 1 » sur un des noeuds de chaque cellule mémoire reliée à cette ligne de bits.

Dans la présente demande de brevet un circuit d'initialisation, en particulier déterministe, selon le sens donné ci-dessus, et qui permet d'imposer une valeur à tout ou partie des cellules d'une même colonne ; cette même valeur ayant été préalablement définie par un procédé de tirage aléatoire.

On utilise par la suite l'expression « initialisation déterministe aléatoire » pour ce type d'initialisation procédant en deux temps, tirage aléatoire puis initialisation « forcée » comme cela sera mieux compris à la lecture des exemples détaillés donnés ci-après.

Le dispositif a ici pour particularité d'associer à chaque colonne COL₁, ..., COLₙ de cellules un circuit 100₁, ..., 100ₙ d'initialisation de colonne, configuré pour mettre en oeuvre une phase d'initialisation des cellules d'une colonne de la matrice dite « initialisation déterministe aléatoire». Les circuits d'initialisation 100₁,...,100ₙ sont typiquement dotés en outre chacun d'une portion en extrémité de colonne et couplés à une paire de ligne de bit parmi l'ensemble de paires de lignes de bits BLT₁, BLF₁,..., BLTₙ, BLFₙ. Chaque circuit 100₁, ..., 100ₙ d'initialisation de colonne est configuré pour, lors d'une initialisation déterministe aléatoire par colonne, initialiser la colonne de cellules à laquelle ce circuit est associé en plaçant l'ensemble des cellules composants cette colonne dans un même état donné. Ce même état d'initialisation est déterminé par l'équivalent d'un « tirage aléatoire » ou pseudo-aléatoire réalisé en dehors de la matrice de cellules et appliqué à tout ou partie des cellules d'une même colonne lors de leur initialisation. Cet état d'initialisation « déterministe aléatoire » est produit de manière aléatoire ou pseudo-aléatoire par un étage de « tirage aléatoire » 110 (non représenté sur cette figure) du circuit d'initialisation 100₁, ..., 100ₙ.

On prévoit de préférence le circuit d'initialisation 100₁, ..., 100ₙ de sorte, que lorsqu'une phase d'« initialisation déterministe aléatoire» est déclenchée des noeuds NA, NB de ce circuit s'établissent de manière aléatoire et selon une probabilité proche de 0.5, respectivement à un premier potentiel entre un potentiel haut ou bas correspondant à un état logique donné, et à un deuxième potentiel entre un potentiel bas ou haut, le deuxième potentiel étant différent du premier potentiel et correspondant à un état logique complémentaire de l'état logique donné.

Ainsi, d'une opération d'initialisation « déterministe aléatoire » à la suivante, chaque colonne COLᵢ peut avoir, en fonction d'un tirage aléatoire, ses cellules C₁ᵢ,..., Cₙᵢ initialisées toutes dans un même état, qui se trouve être le même état que lors d'une initialisation précédente ou bien dans un état opposé. La suite des valeurs d'initialisation d'une même colonne présente un caractère aléatoire.

Consécutivement à une initialisation réalisée par le biais des circuits 100ᵢ, 100j, les cellules respectives C₁ᵢ, ..., Cₙᵢ et C₁ⱼ, ..., Cₙⱼ de colonnes COLᵢ, COLⱼ distinctes peuvent être initialisées, en fonction du tirage aléatoire par colonne réalisé par leurs circuit 100ᵢ, 100ⱼ respectifs, toutes dans un même état (correspondant à un '1' ou un '0' sur un de leurs deux noeuds) mais ce cas est peu probable statistiquement parlant ou dans des états différents d'une colonne COLᵢ, à l'autre COLⱼ.

Ces circuits 100₁, ..., 100ₙ d'initialisation intégrant une initialisation déterministe aléatoire des cellules mémoire permettent de contrer les attaques CPA et DPA pour les zones mémoire où l'utilisateur ne maîtrise pas la valeur d'initialisation. En effet, comme expliqué dans le document susmentionné, pour réaliser ce type d'attaque il est nécessaire de connaître la valeur d'initialisation ou *a minima* de savoir que la valeur d'initialisation est toujours la même. Ces méthodes utilisent souvent une répétition d'une initialisation suivie éventuellement d'une phase de stress et un procédé de post-traitement se basant sur l'hypothèse que les valeurs d'initialisation des cellules sont toujours les mêmes. Ainsi, en utilisant un circuit d'initialisation selon l'invention permettant d'initialiser les cellules de la mémoire à des valeurs non connues et différentes dans le temps, grâce aux tirages aléatoires, il est possible de déjouer ce type d'attaque.

En outre, lorsque les initialisations se répètent et conduisent à des valeurs différentes dans les cellules mémoire, le phénomène de vieillissement dans ces cellules est moindre. En effet, d'un point de vue statistique, si les cellules mémoire sont laissées dans leur état d'initialisation et que celui-ci est changé régulièrement lors des initialisations successives, ce n'est pas toujours le même transistor PMOS qui vieillit plus vite ce qui permet de limiter statistiquement la dérive du rapport des tensions de seuils VTP1/VTP2.

Ces résultats sont obtenus tout en limitant l'impact sur la matrice elle-même en termes d'encombrement du dispositif mémoire. Les circuits 100₁, ..., 100ₙ d'initialisation déterministe aléatoire participent ainsi à la sécurisation matérielle des données de la mémoire.

On note que l'utilisation d'initialisations déterministes aléatoires pour une zone PUF de la mémoire permet également d'améliorer la fiabilité de cette zone PUF en limitant le vieillissement des transistors, ou plutôt en limitant la dérive du ratio VtP2/VTP1 contrairement à un circuit dans lequel l'initialisation de la zone PUF serait toujours réalisée de manière libre, conduisant à la mémorisation des mêmes valeurs dans les cellules mémoire tant que celles-ci n'ont pas trop subit l'effet du NBTI.

La structure interne des cellules C₁₁, ..., Cₙₘ du dispositif mémoire peut, quant à elle, suivre un agencement conventionnel, comme sur la figure 2, où un exemple de structure de cellule SRAM Cᵢⱼ du dispositif mémoire est donné. La cellule Cᵢⱼ est dotée de deux noeuds de stockage N_{T} et N_{F}, prévus pour conserver une première information logique, et une information logique complémentaire de la première information. Le maintien des informations logiques dans les noeuds est assuré par des transistors formant des inverseurs INV1, INV2 bouclés sur eux-mêmes. Par exemple, lorsque la cellule SRAM est de type communément appelé « 6T » et formée ainsi de 6 transistors. Les deux inverseurs INV1, INV2, sont typiquement réalisés par deux transistors de charge et deux transistors de conduction. Les inverseurs INV1, INV2 sont ici connectés à une première ligne d'alimentation, en particulier une ligne d'alimentation dite « haute », et à une deuxième ligne d'alimentation, en particulier une ligne d'alimentation dite « basse ». La ligne d'alimentation est mise à un potentiel dit « haut », par exemple égal à une tension d'alimentation VDD, qui est par conséquent supérieur à celui dit « bas » de la ligne d'alimentation basse, et correspond typiquement à un potentiel de référence ou de masse GND. L'accès aux noeuds de stockage N_{T} et N_{F} est réalisé par le biais de deux transistors d'accès TA_{T} et TA_{F} connectés respectivement à des lignes de bit BLTᵢ et BLFᵢ partagées par les cellules SRAM d'une même colonne COLi de cellules du plan matriciel.

Cet accès aux noeuds de stockage N_{T} et N_{F} est commandé par une ligne de mot WLⱼ généralement partagée par les cellules SRAM d'une même ligne LINj de cellules du plan matriciel. Les transistors d'accès TA_{T} et TA_{F} sont ainsi prévus pour, lorsqu'ils sont activés, permettre l'accès au premier noeud N_{T} et au deuxième noeud N_{F}, ou lorsqu'ils sont désactivés de bloquer l'accès au premier noeud N_{T} et au deuxième noeud N_{F}.

Dans le cas présent, lors d'une phase d'initialisation déterministe aléatoire, les transistors d'accès TA_{T} et TA_{F} respectifs des cellules de la colonne initialisée sont activés pour permettre une initialisation de chaque cellule de la colonne.

Un exemple de réalisation particulier de circuit d'initialisation 100i associé à une colonne COLi de cellules est donné sur la figure 3. Ce circuit d'initialisation 100i ne requiert ici la mise en oeuvre que d'un nombre restreints d'éléments additionnels périphériques au plan mémoire M₁. Le circuit 100i est doté d'un étage 110 de tirage aléatoire, situé en extrémité d'une colonne donnée COLi. Lorsqu'un signal d'activation d'initialisation est appliqué au circuit 100i, ce qui se traduit ici par un front montant ou passage d'un état '0' à un état '1' du signal RAND_ENABLE, l'étage 110 produit, comme évoqué plus haut, de manière aléatoire sur un premier noeud de sortie N_{A} et sur un deuxième noeud de sortie N_{B}, respectivement, un premier potentiel haut ou bas et un deuxième potentiel, bas ou haut mais différent et complémentaire en logique du premier potentiel. Le signal d'activation RAND_ENABLE du mode d'« initialisation déterministe aléatoire » peut être issu d'un contrôleur mémoire.

La figure 3 illustre un exemple de réalisation particulier de l'étage 110 de tirage aléatoire avec ici un nombre de composants et un encombrement limités. Cet étage 110 de tirage aléatoire est formé d'un premier inverseur INVA et d'un deuxième inverseur INVB mutuellement connectés de façon croisée et formés ici chacun d'un transistor 111A, 111B de type PMOS, et d'un transistor 112A, 112B de type NMOS.

On choisit de préférence des transistors 111A, 112A, 111B, 112B de grande taille, par exemple égale à celle des transistors formant un amplificateur de détection à laquelle la colonne COLi est associée.

Le premier inverseur INVA est de préférence conçu avec des transistors 111A, 112A sensiblement identiques aux transistors 111B, 112B du deuxième premier inverseur INVB.

Par « sensiblement identiques » on entend ici que les transistors 111A, 111B d'une part et 112A, 112B d'autre part sont prévus avec des structures et des dimensions semblables et que des différences éventuelles existantes sont dues principalement à des variabilités locales du procédé de fabrication.

De même, de préférence, chaque étage 110 de tirage aléatoire est identique ou sensiblement identique aux autres étages de tirage aléatoire des autres circuits d'initialisation répartis sur des colonnes différentes.

Les inverseurs INVA, INVB de l'étage 110 de tirage aléatoire sont couplés, pour leur alimentation haute, à un premier élément de polarisation, par exemple une ligne d'alimentation LVdd, permettant de délivrer un potentiel d'alimentation haut par exemple Vdd.

Un élément interrupteur, en particulier un transistor 115 interrupteur, ici de type NMOS, est agencé entre un deuxième élément de polarisation et l'étage 110. La grille du transistor 115 interrupteur est commandée par le signal d'activation RAND_ENABLE prévu pour activer une phase d'initialisation déterministe aléatoire.

Le deuxième élément de polarisation, par exemple une ligne d'alimentation LGND, est prévu pour délivrer un potentiel de référence ou de masse GND.

Le circuit d'initialisation 100i est ici également pourvu d'un étage 102 de commutation, doté de transistors 103, 104, en particulier de type PMOS, qui permet de connecter les deux noeuds de sortie NA et NB à un même potentiel, ici un potentiel haut Vdd hors des phases d'initialisation déterministe aléatoire. Les grilles des transistors 103, 104, sont également commandées par le signal d'activation d'initialisation RAND_ENABLE. Hors desdites phases d'« initialisation déterministe aléatoire», le transistor 115 interrupteur isole l'étage 110 du deuxième élément de polarisation, ce qui participe à un maintien des noeuds de sortie NA et NB de l'étage 110 de tirage à un même potentiel en association avec l'action de l'étage de commutation susmentionné.

Le transistor interrupteur 115 est ici prévu pour, consécutivement à la réception ou au changement d'état du signal d'activation d'initialisation RAND_ENABLE, connecter les inverseurs INVA, INVB à la ligne d'alimentation LVss dite « basse », ce qui permet aux noeuds NA et NB de pouvoir pour l'un de se maintenir, et pour l'autre de se décharger.

Lors de phases d'initialisation déterministe aléatoire, l'étage 102 de commutation permet d'isoler les deux noeuds de sortie NA et NB du potentiel d'alimentation haut Vdd, pour permettre aux noeuds de sortie NA et NB de l'étage 110 de s'établir à des potentiels différents, une fois l'étage 110 réalimenter par la mise en conduction du transistor 115.

L'étage 102 de commutation est avantageusement doté ici en outre d'un transistor 105 supplémentaire de commutation, par exemple de type PMOS, entre le premier noeud NA et le deuxième noeud NB afin d'assurer une bonne égalisation des potentiels « de départ » de ces deux noeuds préalablement à la mise sous-tension de l'étage 110 lors de la réalisation d'un nouveau tirage aléatoire.

Le transistor 105 dont la grille est commandée par le signal d'activation d'initialisation RAND_ENABLE est ainsi configuré pour, lors des phases d'« initialisation déterministe aléatoire, isoler l'un de l'autre les noeuds de sortie NA, NB de l'étage 110 de tirage et les connecter l'un à l'autre les noeuds de sortie de l'étage 110 de tirage en dehors de cette phase de tirage aléatoire.

Le circuit 100 d'initialisation comprend également ici un étage de couplage 130 formé ici d'un transistor 131, en particulier de type PMOS, agencé entre le premier noeud NA et la première ligne de bit BLT de la colonne COLi et d'un autre transistor 132, en particulier de type PMOS, agencé entre le deuxième noeud NB et la deuxième ligne de bit BLF de la colonne COLi. Dans l'exemple de réalisation particulier donné sur la figure 3, on prévoit également des inverseurs 123, 124 entre les noeuds NA, NB et l'étage 130 de couplage.

Les grilles respectives des transistors 131, 132 sont commandées par un signal qui dépend du signal RAND_ENABLE, ici en particulier un signal en sortie d'un inverseur 119, fournissant un signal complémentaire du signal RAND_ENABLE.

Hors des phases d'initialisation déterministe aléatoire (RAND_ENABLE = 0), les noeuds NA, NB sont isolés des lignes de bits BLTi, BLFi. Il s'ensuit dans cet exemple de réalisation que les lignes de bits BLTi, BLFi sont pilotées pour réaliser une initialisation libre des cellules mémoire ; les transistors d'accès des cellules étant en complément rendus non conducteurs pour éviter toute influence résiduelle des lignes de bits sur les cellules mémoire, même si les lignes de bits ne sont pas alimentées.

Lors des phases d'initialisation déterministe aléatoire (RAND_ENABLE = 1), les noeuds de sortie NA, NB sont connectées aux lignes de bits BLTi, BLFi afin de pouvoir charger ou décharger les lignes de bits BLTi, BLFi respectivement à un potentiel donné qui dépend de celui auquel s'est établi le premier noeud NA de sortie de l'étage 110 de tirage aléatoire et à un autre potentiel qui dépend de celui auquel s'est établi le deuxième noeud NB et qui correspond à un état logique complémentaire de celui auquel correspond le potentiel donné.

On impose ainsi de cette manière un même état logique à toutes les cellules de la colonne COLi qui sont initialisées par le circuit d'initialisation 110i, cet état logique étant établi de manière aléatoire par la sortie de l'étage 110 de tirage aléatoire. Pour permettre d'initialiser les cellules d'une même colonne, le circuit d'initialisation est typiquement relié à des moyens d'activation simultanée de tout ou partie des lignes de mots de la matrice de cellules.

Sur les figures 4A-4B, deux phases successives d'initialisation déterministe aléatoire d'une même colonne sont illustrées.

Lors d'une première initialisation (figure 4A), consécutivement à la réception ou au changement d'état du signal d'activation RAND_ENABLE, par exemple un front descendant de ce signal RAND_ENABLE, les noeuds NA, NB de sortie sont mis respectivement à un premier potentiel et à un deuxième potentiel (parmi un potentiel haut VDD et un potentiel bas GND ou de référence), de sorte à charger respectivement les lignes de bits BLTi, BLFi au premier ou deuxième potentiel afin d'imposer aux noeuds NT des cellules de cette colonne, un même état logique, en particulier '1' ou '0', et aux noeuds NF des cellules de cette colonne un même état logique en particulier un '0' ou '1'.

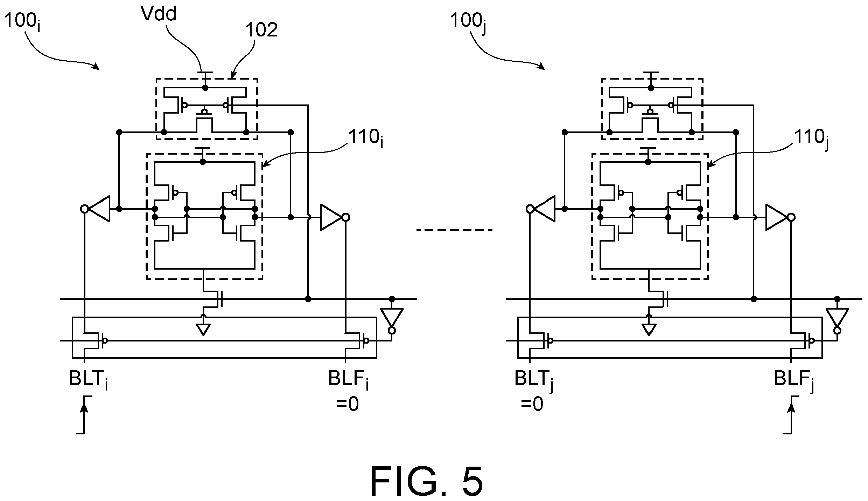

La figure 5, sert à illustrer une phase d'initialisation déterministe aléatoire effectuée sur deux colonnes distinctes d'une même matrice.

Cette phase consécutive à la réception ou au changement d'état du signal d'activation RAND_ENABLE, permet de charger les lignes de bits BLTi, BLFi d'une colonne COLi respectivement à un potentiel haut VDD et à un potentiel bas ou de référence, tandis que les lignes de bits BLTj, BLFj d'une autre colonne COLj sont respectivement à un potentiel bas ou de référence et à un potentiel haut VDD, alors que leurs circuits d'initialisation 100i, 100j qui sont de conception identiques délivrent de manière aléatoire des sortie différentes l'une de l'autre.

On notera que la présente invention peut être mise en oeuvre avec un étage 110 de tirage aléatoire différent de celui décrit précédemment décrit à base d'inverseurs tête bêche. Ainsi d'autres générateurs aléatoires de potentiels distincts correspondant à des états logiques complémentaires peuvent être prévus.

On peut par exemple utiliser un circuit pseudo-aléatoire de génération d'un bit basé sur une graine d'aléa comme il en existe de nombreux.

En outre, au lieu d'avoir n circuits de tirage d'un bit aléatoire, il est possible en variante d'utiliser un unique circuit de tirage d'une suite de n bits aléatoires ou pseudo-aléatoires et de prévoir un dispositif de liaison entre cet unique circuit de tirage de n bits aléatoires et les différents circuits d'initialisation proche colonnes prévus pour piloter l'initialisation des cellules de la colonne à une valeur correspondant à un des bits de la suite de n bits aléatoires.

Par exemple, des oscillateurs bouclés peuvent être utilisés, tout comme des dispositifs optiques ou des PUF a arbitrage, comme décrit dans le document : *"PUF and Applications : A tutorial",* de C. Herder et al., IEEE 2014. Il est suffisant de relier une source d'entropie à n bits à un registre à n bits. Dans ce cas, le circuit 100i associé à chaque colonne comprend uniquement le circuit de couplage 130 (avec les transistors 131, 132) et les transistors 123 et 124 . La sortie du i-ème bit du registre à n bits est reliée directement au noeud NA (entrée du transistor 123) et reliée par l'intermédiaire d'un inverseur au noeud NB (entrée de l'inverseur 124). Autrement dit, le dispositif mémoire comprend dans ce mode de réalisation un étage de tirage de valeur aléatoire partagé au sein de la mémoire remplaçant les n étages 110 de tirage aléatoire du mode de réalisation précédemment décrit en lien avec la figure 3.

Outre une « initialisation déterministe aléatoire» telle que décrite précédemment, un dispositif mémoire suivant l'invention peut être prévu pour effectuer d'autres types d'initialisation, et en particulier des initialisations de type « libre » et/ou « déterministe » telles que décrites dans la deuxième demande de brevet susmentionnée n°2111286 déposée par la demanderesse le 25 Octobre 2021.

Avec un circuit d'initialisation tel que décrit dans la présente demande, on ajoute une nouvelle manière d'initialiser à un même état déterminé de manière aléatoire toutes les cellules d'une même colonne au moyen d'un circuit doté d'une source d'entropie différente de celle des cellules elles-mêmes. La source d'entropie remplit la fonction d'un générateur de bits aléatoires et peut dans certains modes de réalisation être intégrée dans un amplificateur d'écriture en tension dont les sorties pilotent de manière complémentaire les lignes de bits d'une colonne de cellules.

Selon une variante de réalisation, il est possible que l'initialisation déterministe aléatoire soit réalisée non pas sur toutes les cellules d'une même colonne, mais seulement sur une partie des cellules d'une colonne. Dans le cas par exemple où la matrice inclut plusieurs zones avec des propriétés d'accès et de sécurité différentes, on pourra par exemple choisir d'initialiser de façon « déterministe aléatoire » les zones où l'on souhaite maximiser la sécurité et choisir une initialisation libre pour les autres zones moins sensibles. En effet, il faut noter que l'initialisation déterministe nécessite d'alimenter les lignes de bits et l'appel en courant peut devenir significatif si un grand nombre de cellules sont initialisées simultanément. Ainsi, laisser une initialisation libre pour les cellules non critiques et réserver l'initialisation déterministe pour les cellules sensibles peut être un bon compromis en terme de consommation et de pic de courant pour le dispositif mémoire. De façon générale, on peut donc prévoir une initialisation déterministe aléatoire pour une partie seulement des cellules d'une colonne en prévoyant des moyens de sélection de ligne permettant de mettre en conduction les transistors d'accès uniquement des cellules que l'on souhaite initialiser selon ce mode.

Selon une autre variante de réalisation, il est également possible de prévoir une initialisation déterministe aléatoire qui se base sur un circuit d'initialisation similaire à celui décrit dans la deuxième demande de brevet n°2111286 déposée par la demanderesse le 25 Octobre 2021, à savoir un circuit de pilotage qui prévoit d'alimenter uniquement une des lignes BLT ou BLF en fonction de la valeur que l'on souhaite imposer qui a été préalablement définie par tirage aléatoire. Ainsi, on peut par exemple modifier le circuit de la figure 3 pour prévoir un pilotage des transistors 131 et 132 en fonction, non seulement du signal RAND_ENABLE, mais également des valeurs présentes en sortie des inverseurs 123 et 124 après réalisation du tirage aléatoire. De façon similaire, dans le cas d'une utilisation d'un générateur de nombre pseudo-aléatoire, l'activation de l'un des transistors 131 ou 132 peut également être conditionnée à la valeur du bit du registre donnant le nombre aléatoire après réalisation d'un tirage aléatoire.

Alternativement, il est possible de prévoir un circuit de pilotage qui pilote toujours la même ligne de bits BLi ou BLFi (et pas l'autre) mais impose soit une tension d'alimentation Vdd, soit une tension GND de référence.

De telles variantes de réalisation dit « single » d'un circuit d'initialisation déterministe aléatoire permettent de limiter les appels de courant qui peuvent être conséquents lorsque le nombre de cellules est élevé. Un inconvénient d'un tel circuit d'initialisation « single » par rapport à un circuit d'initialisation « différentiel » tels que ceux décrits précédemment en lien avec les figures 1 et 3 est que l'opération d'initialisation est généralement plus lente et potentiellement susceptible de présenter une probabilité non nulle d'erreur d'initialisation, une telle erreur pouvant néanmoins être acceptable dans certaines applications. Ainsi, dans le cas où on souhaite privilégier avant tout la vitesse d'initialisation, il faudra éventuellement prévoir de partitionner la matrice mémoire et d'avoir des colonnes de taille raisonnables pouvant être initialisés par un même circuit différentiel.

En outre, l'initialisation déterministe aléatoire peut être appliquée en parallèle à tout ou partie des colonnes de la matrice. En effet, il se peut, par exemple pour des questions de gestion de pics de courant, qu'il soit nécessaire de procéder à l'initialisation des colonnes de façon séquentielle, éventuellement par blocs de colonne. En outre, selon l'architecture et l'organisation de la matrice mémoire, il est possible que seules certaines colonnes hébergent des cellules mémoire sensibles, par exemple car elles stockent des données sensibles, pour lesquelles il soit jugé opportun d'appliquer une initialisation déterministe aléatoire.

## Revendications

1. Dispositif de mémoire comprenant une matrice mémoire (M₁) agencée en lignes (LIN₁,...,LINₘ) et en colonnes (COL₁,...,COLₙ) de cellules mémoires (C₁₁,..., Cₙₘ) SRAM, chaque colonne comprenant une première ligne de bit (BLTi) et une deuxième ligne de bit complémentaire (BLFi) reliées respectivement à des transistors d'accès des cellules mémoire de la colonne, chaque colonne étant associée à un circuit d'initialisation (100i, 100j) comprenant un premier élément de couplage (131) et un deuxième élément de couplage (132) placés respectivement entre d'une part les première et deuxième lignes de bits de la colonne associée et d'autre part un bloc de pilotage, le bloc de pilotage étant apte à imposer une tension sur les lignes de bit quand au moins un desdits éléments (131, 132) de couplage est rendu conducteur dans un mode d'initialisation déterministe de tout ou partie des cellules de la colonne, et dans lequel ledit bloc de pilotage comprend au moins un étage (110) de tirage de valeur aléatoire, pour générer une valeur ou un état logique parmi deux valeurs ou états logiques '0' ou '1' possibles associé à une colonne, et dans lequel, dans une phase d'initialisation dite déterministe aléatoire, le bloc de pilotage commande successivement pour au moins une colonne sélectionnée :
- la génération d'une valeur aléatoire par ledit étage (110) de tirage de valeur aléatoire associé à chaque colonne sélectionnée ; puis
- la mise en conduction d'au moins un élément de couplage parmi lesdits premier et deuxième éléments de couplage d'un circuit d'initialisation associé à chaque colonne sélectionnée pour relier au moins une des lignes de bits au bloc de pilotage qui impose une valeur de tension, le choix dudit élément couplage mis en conduction ou le choix de la valeur de tension imposée étant fonction de la valeur aléatoire préalablement générée pour la colonne sélectionnée, et la mise en conduction simultanée d'au moins un transistor d'accès d'au moins une cellule de la colonne sélectionnée.

2. Dispositif de mémoire selon la revendication 1 dans lequel l'étage (110) de tirage de valeur aléatoire est apte à être couplé à une colonne (COLᵢ) de cellules parmi lesdites colonnes et doté d'un premier noeud (NA) de sortie et d'un deuxième noeud (NB) de sortie, ledit étage (110) de tirage de valeur aléatoire étant configuré pour, consécutivement à la réception d'un signal d'activation d'initialisation (RAND_ENABLE), produire, de manière aléatoire, respectivement un premier potentiel au premier noeud (NA) correspondant à un état logique donné et un deuxième potentiel au deuxième noeud (NB) de sortie différent du premier potentiel et correspondant à un état logique donné complémentaire dudit état logique donné,
au moins un premier circuit d'initialisation (100i) associé à une première colonne (COLᵢ) étant configuré pour, préalablement à une phase d'initialisation déterministe aléatoire :
- isoler le premier noeud (NA) de sortie et le deuxième noeud (NB) de sortie respectivement d'une première ligne de bit (BLTi) et d'une deuxième ligne de bit (BLFi) de ladite première colonne (COLi) tout en mettant le premier noeud (NA) de sortie et le second noeud (NB) à un même potentiel,
puis, lors de la phase d'initialisation déterministe aléatoire déclenchée par la réception dudit signal d'activation d'initialisation (RAND_ENABLE),
- laisser le premier noeud (NA) de sortie et le second noeud (NB) s'établir respectivement à des potentiels différents, tout en couplant le premier noeud (NA) de sortie à ladite première ligne de bit et le deuxième noeud (NB) de sortie à ladite deuxième ligne de bit de la première colonne.

3. Dispositif de mémoire selon la revendication 2, dans lequel ledit étage (110) de tirage de valeur aléatoire est doté d'un premier inverseur (INVA) et d'un deuxième inverseur (INB) mutuellement connectés de façon croisée.

4. Dispositif de mémoire selon l'une des revendications 2 ou 3, dans lequel le circuit d'initialisation (100i, 100j) comprend :
- un étage (102) de commutation à transistors (103, 104, 105), agencé entre un premier élément de polarisation (L'Vdd) et les noeuds (NA, NB) de sortie dudit étage (110) de tirage de valeur aléatoire, configuré pour, hors de phases d'initialisation déterministe aléatoire, connecter les noeuds (NA, NB) de sortie dudit étage (110) de tirage de valeur aléatoire au premier élément de polarisation (LVdd) et pour isoler les noeuds de sortie de l'étage (110) de tirage de valeur aléatoire dudit premier élément de polarisation (LVdd) lors desdites phases d'initialisation déterministe aléatoire,
- un élément interrupteur, en particulier un transistor (115), configuré pour, hors desdites phases d'initialisation déterministe aléatoire, isoler ledit étage (110) de tirage de valeur aléatoire (110) d'un deuxième élément de polarisation (LGND) et lors desdites phases d'initialisation déterministe aléatoire, connecter ledit étage (110) de tirage de valeur aléatoire audit deuxième élément de polarisation (LGND).

5. Dispositif de mémoire selon la revendication 4, dans lequel l'étage (102) de commutation à transistors (103, 104, 105) est configuré en outre pour, hors desdites phases d'initialisation déterministe aléatoire, isoler l'un de l'autre les noeuds (NA, NB) de sortie dudit étage (110) de tirage de valeur aléatoire et lors desdites phases d'initialisation déterministe aléatoire, connecter l'un à l'autre les noeuds (NA, NB) de sortie dudit étage (110) de tirage de valeur aléatoire.

6. Dispositif de mémoire selon l'une des revendications 2 à 5, dans lequel le premier élément de couplage est un premier transistor (131) de couplage entre la première ligne de bit (BLT) et un premier noeud de sortie (NA) de l'étage (110) de tirage de valeur aléatoire,
dans lequel le deuxième élément de couplage est un deuxième transistor (132) de couplage agencé entre la deuxième ligne de bit (BLF) et un deuxième noeud de sortie (NB) de l'étage (110) de tirage de valeur aléatoire, le premier transistor (131) de couplage et le deuxième transistor (132) de couplage étant commandés par ledit signal d'activation d'initialisation déterministe aléatoire (RAND_ENABLE).

7. Dispositif de mémoire selon la revendication 1, dans lequel ledit l'étage (110) de tirage de valeur aléatoire comprend un étage partagé de tirage d'un nombre aléatoire sur plusieurs bits, chaque bit étant associé à une colonne.

8. Dispositif de mémoire selon l'une des revendications 1 à 7, dans lequel une première colonne est associée à un premier étage (110i) de tirage de valeur aléatoire, une deuxième colonne étant associée à un deuxième étage (110j) de tirage de valeur aléatoire.

9. Dispositif de mémoire selon l'une des revendications 1 à 7, dans lequel au moins une partie de la matrice de cellules mémoire inclut des cellules dites sensibles et comprenant un contrôleur mémoire apte à imposer une initialisation déterministe aléatoire de ces cellules sensibles lors d'une mise sous tension du dispositif mémoire ou consécutivement à une opération d'effacement de la matrice mémoire.
